(19) Europäisches Patentamt
European Patent Office
Office européen des brevets

(11) **EP 4 664 175 A1**

(12) **EUROPEAN PATENT APPLICATION**
published in accordance with Art. 153(4) EPC

(43) Date of publication:
**17.12.2025 Bulletin 2025/51**

(21) Application number: **24836384.8**

(22) Date of filing: **05.07.2024**

(51) International Patent Classification (IPC):
**G02B 13/00** (2006.01)    **G02B 26/08** (2006.01)
**G02B 17/08** (2006.01)

(52) Cooperative Patent Classification (CPC):
**G02B 13/0065; H10F 39/806**

(86) International application number:
**PCT/KR2024/009603**

(87) International publication number:
**WO 2025/009937 (09.01.2025 Gazette 2025/02)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 05.07.2023 KR 20230087208
27.09.2023 KR 20230130364

(71) Applicant: **Samsung Electronics Co., Ltd.
Suwon-si, Gyeonggi-do 16677 (KR)**

(72) Inventors:
- **SHIN, Jeongkil**
  **Suwon-si Gyeonggi-do 16677 (KR)**
- **KIM, Haneung**
  **Suwon-si Gyeonggi-do 16677 (KR)**
- **SHIM, Jaekyu**
  **Suwon-si Gyeonggi-do 16677 (KR)**
- **LEE, Kihuk**
  **Suwon-si Gyeonggi-do 16677 (KR)**

(74) Representative: **HGF
HGF Limited
4th Floor, 1 City Square
Leeds LS1 2AL (GB)**

(54) **OPTICAL MEMBER AND ELECTRONIC DEVICE COMPRISING SAME**

(57) According to an embodiment, an electronic device may comprise: at least one lens, an image sensor aligned along an optical axis from the at least one lens, and an optical member disposed between the at least one lens and the image sensor on the optical axis. The optical member may include a first optical member including a first surface on which light passing through the at least one lens is configured to be incident, a second surface inclined with respect to the first surface, and a third surface inclined with respect to the first surface and the second surface, and a second optical member including a fourth surface through which light is configured to exit, a fifth surface inclined with respect to the fourth surface, and a sixth surface inclined with respect to the fourth surface and the fifth surface and configured to face the third surface. Other various embodiments are also available.

FIG. 3

## Description

### [Technical Field]

The disclosure relates to, e.g., an optical member and an electronic device including the optical member.

### [Background Art]

Optical devices, e.g., cameras capable of capturing images or videos have been widely used. Conventional film-type cameras are being recently replaced with digital cameras or video cameras with a solid image sensor, such as charge coupled device (CCD) or complementary metal-oxide semiconductor (CMOS) because Solid image sensor (CCD or CMOS)-adopted cameras may easily save, copy, or move images as compared with film-type cameras and have thus been replacing film-type cameras.

As the main consumption model of cameras shifts from conventional compact cameras to camera modules embedded in smart phones, the biggest issue in the camera-related industry is focused on miniaturization while maintaining high camera optical capability. As the camera has more and more lenses, and has a larger imaging plane (image sensor), the quality of the image obtained thereby may increase. In other words, high image quality and miniaturization are in a trade-off relationship, and to address this, an embodiment employing multiple single-focus lens-type camera modules in one electronic device has been applied.

The above-described information may be provided as background for the purpose of helping understanding of the disclosure. No claim or determination is made as to whether any of the foregoing is applicable as background art in relation to the disclosure.

### [Disclosure of Invention]

### [Solution to Problems]

According to an example embodiment, an electronic device may comprise: at least one lens, an image sensor aligned along an optical axis from the at least one lens, and an optical member disposed between the at least one lens and the image sensor on the optical axis. The optical member may include a first optical member including a first surface on which light passing through the at least one lens is incident, a second surface inclined with respect to the first surface, and a third surface inclined with respect to the first surface and the second surface, and a second optical member including a fourth surface through which light is configured to exit, a fifth surface inclined with respect to the fourth surface, and a sixth surface inclined with respect to the fourth surface and the fifth surface and configured to face the third surface.

According to an example embodiment, an electronic device may comprise at least one lens, an image sensor aligned along an optical axis from the at least one lens, and an optical member disposed between the at least one lens and the image sensor on the optical axis. The optical member may include a first optical member having a triangular column shape and configured to allow light passing through the at least one lens to be incident through at least one surface thereof, and a second optical member having a triangular column shape, configured to allow light to exit through at least one surface thereof, and configured to face the first optical member through at least one other surface thereof.

### [Brief Description of Drawings]

The foregoing and other aspects, features, and/or advantages of certain embodiments of the present disclosure will be more apparent from the following detailed description, taken in conjunction with the accompanying drawings, in which:

FIG. 1 is a diagram illustrating an example camera module including an optical member according to an embodiment of the disclosure;
FIG. 2 is a diagram illustrating an example camera module including an optical member according to an embodiment of the disclosure;
FIG. 3 is a diagram illustrating an example optical member according to an embodiment of the disclosure;
FIG. 4 is a diagram illustrating an example optical member base material according to an embodiment of the disclosure;
FIG. 5 is a diagram illustrating an example optical member base material having a cutting plane according to an embodiment of the disclosure;
FIG. 6 is a diagram illustrating an example optical member base material having a notch according to an embodiment of the disclosure;
FIG. 7 is a perspective view illustrating an example optical member base material having a notch according to an embodiment of the disclosure;
FIG. 8 is a diagram illustrating an example optical member according to an embodiment of the disclosure;
FIG. 9 is a diagram illustrating an example optical member base material according to an embodiment of the disclosure;
FIG. 10 is a perspective view illustrating an example optical member including a blocking film according to an embodiment of the disclosure;
FIG. 11 is a perspective view illustrating an example optical member including a blocking film according to an embodiment of the disclosure;
FIG. 12 is a block diagram illustrating an example electronic device in a network environment according to various embodiments; and

FIG. 13 is a block diagram illustrating an example configuration of a camera module according to various embodiments.

Throughout the drawings, like reference numerals may be assigned to like parts, components, and/or structures.

**[Mode for the Invention]**

In the case of employing several single-focus lens-type camera modules in one electronic device, generally, a zooming effect may be created by making each single-focus lens-type camera module have a different focal length and properly mixing with digital zoom. Camera modules typically adopted include, e.g., wide cameras (e.g., ultra-wide cameras) having a shorter focal length than the wide camera having a focal length of 24 to 35mm and cameras (e.g., tele cameras) having a longer focal length than that with respect to the 35mm camera optical lens system. Among them, the tele camera which has a relatively long (generally five times longer) focal length requires a longer mounting space in the longitudinal direction than that of the other cameras, it may adopt an optical lens system including a lens having a smaller diameter than the wide camera. However, as the market gradually requires higher zoom performance, it is harder to mount a camera in a limited space. To address such issues, electronic devices including a camera module adopting a folded (or curved) optical lens system with excellent mountability are being developed. A camera module adopting a specific folded optical lens system may be made by shortening the light incident path while maintaining the effective focal length making light refracted and/or reflected two or more times. A camera module adopting a refractive optical system may include a prism (and/or mirror) as an optical member for refracting and/or reflecting light.

A camera module including a folded optical lens system may generate stray light (or flare) in which the light reflected along an unwanted light path in the optical member is imaged on the image sensor as it is. Various studies are being conducted to prevent and/or reduce flare.

Various embodiments of the disclosure disclose an optical member and an electronic device including the same. According to the optical member and the electronic device including the same according to the disclosure, it is possible to effectively prevent and/or reduce flare.

The disclosure is not limited to the foregoing, and other unmentioned effects will be apparent to one of ordinary skill in the art from the following description.

The following description taken in conjunction with the accompanying drawings may provide an understanding of various example implementations of the disclosure, including claims and their equivalents. The various example embodiments disclosed in the following description entail various specific details to aid understanding, but are regarded as examples among various embodiments. Accordingly, it will be understood by those skilled in the art that various changes and modifications may be made to the various implementations described in the disclosure without departing from the scope and spirit of the disclosure. Further, descriptions of well-known functions and configurations may be omitted for clarity and brevity.

The terms and words used in the following description and claims are not limited to the bibliographical meaning, but may be used to clearly and consistently describe an embodiment of the disclosure. Therefore, it will be apparent to those skilled in the art that the following description of various implementations of the disclosure is provided simply for the purpose of description, not for the purpose of limiting the disclosure defined as the scope of the claims and equivalent thereto.

The singular forms "a," "an," and "the" are intended to include the plural forms as well, unless the context clearly indicates otherwise. Thus, as an example, "a component surface" may be interpreted as including one or more of the surfaces of a component.

In the following embodiments, there may be provided various embodiments of a camera module capable of reducing or preventing stray light. The camera module may be mounted and used in various electronic devices. Hereinafter, various example embodiments of the present disclosure are described with reference to the accompanying drawings.

For example, examples of the electronic device according to an embodiment of the present disclosure may include, for example, and without limitation, at least one of a smartphone, a tablet personal computer (PC), a mobile phone, a video phone, an e-book reader, a desktop PC, a laptop computer, a netbook computer, a workstation, a PDA (personal digital assistant), a portable multimedia player (PMP), an MP3 player, a mobile medical device, a camera, a wearable device, or the like. The wearable device may include, for example, and without limitation, at least one of an accessory-type device (e.g., a watch, a ring, a bracelet, an anklet, a necklace, glasses, contact lenses, or a head-mounted device (HMD)), a fabric- or clothes-integrated device (e.g., electronic clothes), a body attaching-type device (e.g., a skin pad or tattoo), a body implantable device, or the like. In various embodiments, examples of the smart home appliance may include, for example, and without limitation, at least one of a television, a digital video disk (DVD) player, an audio player, a refrigerator, an air conditioner, a cleaner, an oven, a microwave oven, a washer, a drier, an air cleaner, a set-top box, a home automation control panel, a security control panel, a TV box (e.g., Samsung HomeSync™, Apple TV™, or Google TV™), a gaming console (Xbox™, PlayStation™), an electronic dictionary, an electronic key, a camcorder, an electronic picture frame, or the like.

According to an embodiment, examples of the electronic device may include, for example, and without limitation, at least one of various medical devices (e.g., diverse portable medical measuring devices (a blood sugar measuring device, a heartbeat measuring device, or a body temperature measuring device), a magnetic resource angiography (MRA) device, a magnetic resource imaging (MRI) device, a computed tomography (CT) device, an imaging device, or an ultrasonic device), a navigation device, a global navigation satellite system (GNSS) receiver, an event data recorder (EDR), a flight data recorder (FDR), an automotive infotainment device, an sailing electronic device (e.g., a sailing navigation device or a gyro compass), avionics, security devices, vehicular head units, industrial or home robots, drones, automatic teller's machines (ATMs) of financial organizations, point of sales (POS) devices of stores, or Internet of things devices (e.g., a bulb, various sensors, a sprinkler, a fire alarm, a thermostat, a street light, a toaster, fitness equipment, a hot water tank, a heater, or a boiler), or the like. According to various embodiments, examples of the electronic device may at include, for example, and without limitation, least one of part of furniture or building/structure, an electronic board, an electronic signature receiving device, a projector, various measurement devices (e.g., devices for measuring water, electricity, gas, or electromagnetic waves), or the like. In various embodiments, the electronic device may be flexible, or a combination of two or more of the various devices described above. According to an embodiment of the disclosure, the electronic devices are not limited to those described above. As used herein, the term "user" may denote a human or another device (e.g., an artificial intelligent electronic device) using the electronic device. The electronic devices according to an embodiment are not limited to those described above.

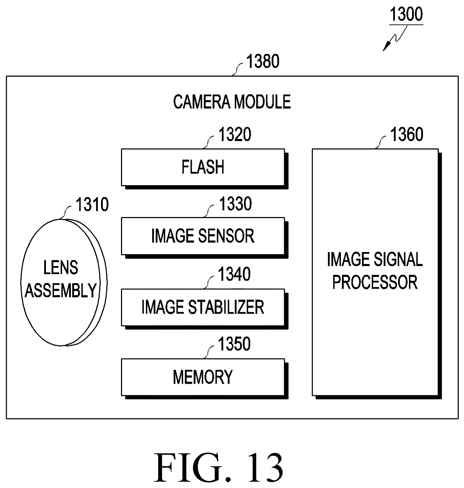

According to an embodiment, representative examples of the electronic device may include optical devices (e.g., camera module 100), and the following description may be based on a lens assembly (e.g., the lens assembly 1310 of FIG. 13) being equipped in an optical device (e.g., camera module 100) according to an embodiment.

Although some numbers are presented in describing an embodiment of the disclosure, it should be noted that the numbers do not limit the embodiment of the disclosure as long as the numbers are not set forth in the claims.

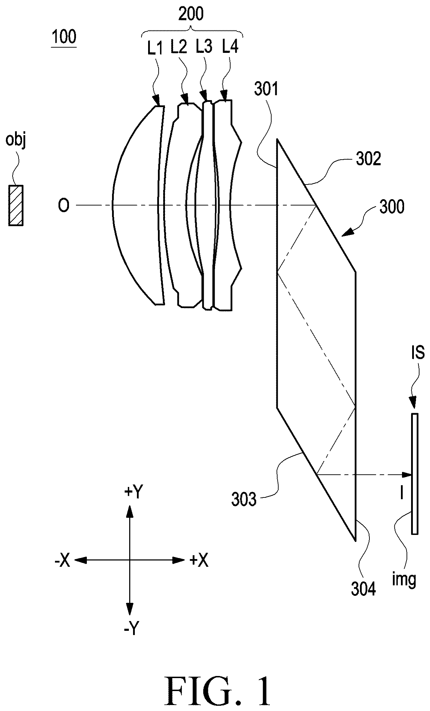

FIG. 1 is a diagram illustrating an example camera module including an optical member according to an embodiment of the disclosure.

In the following detailed description, the length direction, the width direction, and/or the thickness direction of the component(s) included in the camera module 100 and/or the camera module 100 may be mentioned, and the length direction may be defined as the 'Y-axis direction', the thickness direction may be defined as the 'X-axis direction', and the width direction may be defined as the 'X-axis direction and a direction perpendicular to the Y-axis direction'. The 'direction perpendicular to the X-axis direction and the Y-axis direction' may refer, for example, to the 'Z-axis direction' of the Cartesian coordinate system. In an embodiment, the direction in which the surface of a component faces may refer, for example, to the direction in which a normal drawn from the surface of the component faces. In an embodiment, 'negative/positive (-/+)' may be mentioned together with the Cartesian coordinate system illustrated in the drawings with respect to the direction in which the component is oriented. For example, the surface facing the object side of the lens (e.g., the first lens L1) closest to the object side O of the camera module 100 and/or the incident surface 301 of the optical member 300 may be defined as a "surface facing in the -X-axis direction", and the surface facing the image side I of the lens (e.g., the fourth lens L4) closest to the image sensor IS side of the camera module 100 and/or the exit surface 304 of the optical member 300 may be defined as a "surface facing in the +X-axis direction". However, the description of the directions is not limited thereto. Although not separately illustrated in the drawings, when the electronic device where the camera module 100 is mounted is a portable terminal such as a smartphone, the front surface of the electronic device may be referred to as a "surface facing in the -X-axis direction" and the rear surface of the electronic device may be referred to as a "surface facing in the +X-axis direction". When the camera module 100 is a front camera mounted on the electronic device, a surface of the lens (e.g., the first lens L1) closest to the object (obj) side O of the camera module 100 that faces the object side may face in the same direction as the front surface of the electronic device. When the camera module 100 is a rear camera mounted on the electronic device, a surface of the lens (e.g., the first lens L1) closest to the object (obj) side O of the camera module 100 that faces the object side may face in the same direction as the rear surface of the electronic device. As such, in the description of the directions, the directions are simply divided for convenience and do not limit the arrangement directions of the camera module 100 and the component(s), and may be set in various ways according to an embodiment. In an embodiment, the 'X-axis direction' may refer, for example, to both the '-X direction' and the '+X direction'. In an embodiment, the 'X-axis direction' may refer, for example, to both the '-X-axis direction' and the '+X-axis direction'. For example, the thickness of the electronic device may refer, for example, to a distance between the front surface (e.g., the surface facing in the -X-axis direction) of the electronic device and the rear surface (e.g., the surface facing in the +X-axis direction) of the electronic device, and the thickness direction of the electronic device may be referred to as an 'X-axis direction'. For example, the thickness of the electronic device may be referred to as the distance between the front surface (the surface facing in the -X-axis direction) of the electronic device and the rear surface (the surface facing in the +X-axis direction) of the electronic device, and the thickness direction of the electronic device may be referred to as the 'X-axis direction'. It should be noted that the directions are so referenced with respect to the Cartesian coordinate system shown in the drawings for the sake of brevity of description, and the description of these directions or components do not limit an embodiment(s) of the disclosure.

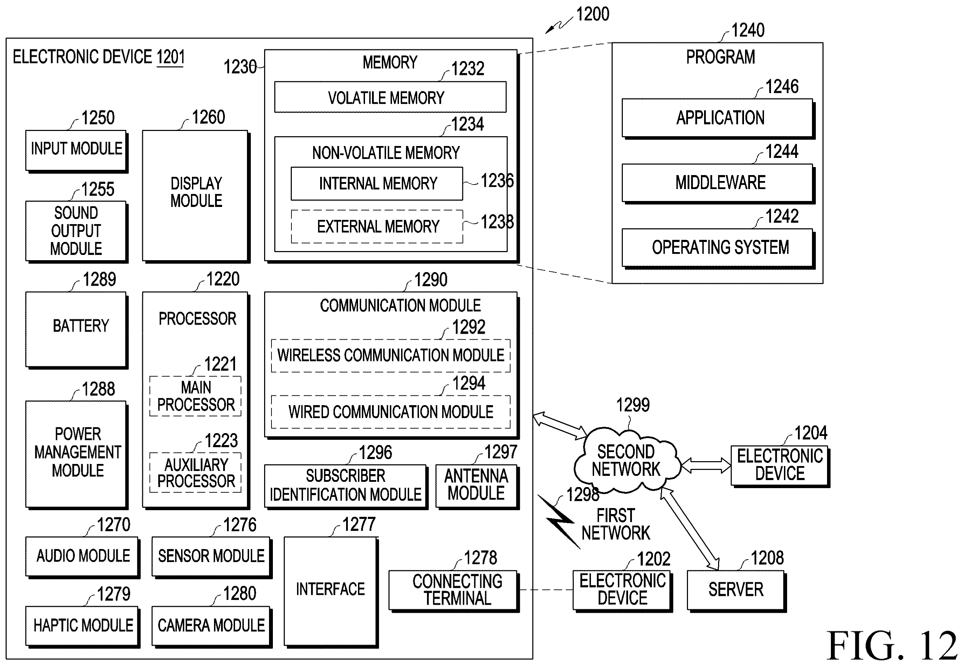

According to an embodiment, the electronic device (e.g., the electronic device 1201 of FIG. 12) may include, for example, and without limitation, at least one of a wide camera, an ultra-wide camera, a close-up camera, a tele camera, or an infrared photodiode as a lens assembly, a light-receiving element, or the like and may include a flash or an infrared laser diode as a light source or a light-emitting element. In an embodiment, the electronic device may emit infrared laser to the subject and receive the infrared laser reflected by the subject, using the infrared laser diode and infrared photo diode, thereby detecting the distance or depth to the subject. In an embodiment, the electronic device may photograph the object using the camera module 100 that combines any one or two or more of the above-mentioned cameras, and may provide light toward the object using the flash if necessary.

According to an embodiment, among the cameras that may be included in the camera module 100, the wide camera, the ultra-wide camera, or the close-up camera may have a smaller lens total length along the optical axis direction of the lens(s) as compared with the tele camera. For example, the lens total length of the tele camera(s) having a relatively long focal length may be greater than that of other cameras. The 'lens total length' may be a distance from the object side surface of the first lens L1 on the object side O to the imaging plane img of the image sensor IS. In an embodiment, even if the wide camera, the ultra-wide camera, or the close-up camera arrange the lens(s) along the thickness direction (e.g., +X axis and/or -X axis direction) of the electronic device, the effect on the thickness of the electronic device may be substantially smaller than that of the tele camera. For example, a wide camera, an ultra-wide camera, or a close-up camera may be disposed in the electronic device in a state in which the direction in which light is incident from the outside to the electronic device and the direction of the optical axis of the lens(s) are substantially the same. These wide cameras, ultra-wide cameras, or close-up cameras may form direct optical lens systems. In an embodiment, when compared with a wide camera, an ultra-wide camera, or a close-up camera, a tele camera has a small field of view, but may be useful for photographing the object at a longer distance. The tele camera may include more lenses as compared to a wide camera, an ultra-wide camera, or a close-up camera. For example, when the lens group 200 including at least one lens is arranged in the thickness direction (e.g., +X axis and/or -X axis direction) of the electronic device, the thickness of the electronic device may increase, or the lens group 200 may substantially protrude to the outside of the electronic device. The tele camera may include at least one reflective member (or refractive member) 300 that reflects or refracts light incident on the lens group 200 in another direction to reduce the thickness of the electronic device including the lens group 200. In implementing the telephoto function, the lens group 200 including at least one lens(s) may be arranged to move forward and backward in the incident direction of light or the traveling direction of the reflected or refracted light, thereby preventing or reducing the thickness of the electronic device from increasing.

According to an embodiment, the electronic device may include a camera module 100 having an optical axis (O-I) (denoted in the dash-dotted line of FIG. 1) from an object side (O) to an image side (I). Here, the object side may indicate a direction in which the object obj is positioned, and the image side may indicate a direction in which the imaging plane img is formed. Further, the "surface facing the object side O" of the lens may be, e.g., a surface facing the object obj with respect to the optical axis O-I and may refer to a left surface (or front surface) of the lens in the drawings according to an embodiment of the disclosure, and the "surface facing the image side I" may be a surface facing the imaging plane img with respect to the optical axis O-I and may refer to a right surface (or rear surface) of the lens in the drawings. The imaging plane img may be a portion where, e.g., an image capturing element or image sensor IS is disposed, and an image forms. The optical axis O-I may refer, for example, to a light path passing through the center of the at least one lens and the center of the image sensor IS when the lens group 200 including the at least one lens and the image sensor IS are aligned. In the case of the camera module 100 forming the direct type optical lens system, the optical axis O-I may be formed to parallel to any one direction (e.g., the X-axis direction) of the Cartesian coordinate system. In the camera module 100 forming the curved optical lens system, the optical axis O-I may include a light path parallel to any one direction (e.g., the X-axis direction) of the Cartesian coordinate system, and may also include a light path whose traveling path is bent not to be parallel to the Cartesian coordinate system.

Hereinafter, according to an embodiment, in describing the plurality of lenses (e.g., L1, L2, L3, and L4), the portion of each lens, which is close to the optical axis O-I may be referred to as a chief portion, and the portion further from the optical axis O-I (or around the edge of the lens) may be referred to as a marginal portion. The chief portion may be, e.g., a portion crossing the optical axis O-I in the first lens L1. The marginal portion may be, e.g., a portion spaced apart from the optical axis by a predetermined distance in the first lens L1. The marginal portion may include an end portion of the lens which is positioned farthest from the optical axis O-I of the lens. In the disclosure, in describing the direction in which the lens included in the camera module 100 faces, the direction may refer, for example, to the direction in which the chief portion or the marginal portion of the corresponding lens surface faces.

The camera module 100 illustrated in FIG. 1 is a tele camera including a lens group 200 including at least one lens(s) and an image sensor IS, and may include a folded optical lens system (a curved optical lens system) configured such that the traveling direction of light is bent at least twice. The camera module 100 including such a folded optical lens system may be referred to as a 'folded camera'. The folded camera may include an optical member 300 capable of reflecting and/or refracting the traveling direction of light at least twice between the lens group 200 including at least one lens and the image sensor IS so as to bend the traveling direction of light at least twice.

According to an embodiment, the lens group 200 may include one lens or may include a combination of a plurality of lenses. For example, the lens group 200 may include a first lens L1, a second lens L2, a third lens L3, and a fourth lens L4. A plurality of lenses (e.g., L1, L2, L3, and L4) may be disposed in an optical axis (O-I) alignment state with the image sensor IS. In the drawings, e.g., four lenses (e.g., L1, L2, L3, and L4) are illustrated, but are not necessarily limited thereto. A smaller number of lenses or a larger number of lenses may be disposed than those illustrated in the drawings.

The image sensor IS may be configured to detect light reflected and/or refracted by the optical member 300 and incident on the imaging plane img. For example, light incident from the outside of the camera module 100 may be detected by the image sensor IS via the lens group 200 and the optical member 300, and the electronic device may obtain an object image based on a signal or information detected through the image sensor IS. According to an embodiment, in performing the image stabilization operation, the image sensor IS may be shifted in the length direction (e.g., +Y or -Y-axis direction) or the width direction (e.g., a direction perpendicular to +X-axis and -X-axis) of the camera module 100. In an embodiment, when it is used as a tele camera, the image quality of the captured image may be increased by being equipped with an image stabilization function. In an embodiment, when the image sensor IS becomes larger, the optical performance of the camera module 100 may be further increased.

The optical member 300 may be disposed between the lens group 200 and the image sensor IS. The light incident on the lens group 200 from the outside may be reflected at least twice through the optical member 300 and may be focused or aligned with the image sensor IS. Accordingly, the optical lens system from the lens group 200 to the image sensor IS may be downsized. A camera having such a structure may be referred to as a 'lens lead type camera'.

The optical member 300 may include a prism, a mirror that reflects light, an aperture, and/or a combination thereof. For example, the optical member 300 may be provided with a prism on one side and a mirror reflecting light on the other side. Further, e.g., the optical member 300 may be configured such that at least two surfaces thereof are formed of prisms to reflect or refract light. According to an embodiment, the optical member 300 may be formed by a combination of a plurality of prisms and/or mirrors. According to an embodiment, the optical member 300 may be formed by combining a plurality of prism pieces and/or mirror pieces. For example, the optical member 300 may be formed by combining prism pieces having a triangular and/or rectangular cross section and/or mirror pieces to form one optical member 300 illustrated in FIG. 1.

Referring to FIG. 1, the optical member 300 may include an incident surface 301 where light passing through the lens group 200 is incident, a first reflective surface 302 inclined with the incident surface 301, and a second reflective surface 303 inclined with the incident surface 301 and spaced apart from the first reflective surface 302.

The incident surface 301 may be a surface through which light passing through the lens group 200 first enters the optical member 300. According to an embodiment, the incident surface 301 may be formed to be spaced apart from a lens (e.g., the fourth lens L4) closest to the image side I of the lens group 200 by a predetermined distance in the direction of the image side I. According to an embodiment, the incident surface 301 may be parallel to the front surface (e.g., a surface parallel to the -X-axis direction) and the rear surface (e.g., a surface parallel to the +X-axis direction) of the electronic device, respectively, and the optical axis O-I may be orthogonal to the incident surface 301. According to an embodiment, an opening may be formed in at least a portion of the incident surface 301, or a prism or mirror capable of transmitting light may be formed to transmit light. The first reflective surface 302 may be a surface where light incident on the incident surface 301 is initially reflected or refracted.

The optical member 300 may include an exit surface 304 which light passing through the optical member 300 exits.

Light IL incident perpendicular to the incident surface 301 of the optical member 300 may pass through an internal space (e.g., an optical waveguide) surrounded by the incident surface 301, the first reflective surface 302, the second reflective surface 303, and the exit surface 304 of the optical member 300 and may exit perpendicular to the exit surface 304. According to an embodiment, the incident surface 301 of the optical member 300 may be referred to as a "first surface", the first reflective surface 302 may be referred to as a "second surface", the second reflective surface 303 may be referred to as a "third surface", and the exit surface 304 may be referred to as a "fourth surface".

The exit surface 304 through which light is emitted may be formed to be spaced apart from the incident surface 301 as a surface different from the incident surface 301 through which light is incident. According to an embodiment, the exit surface 304 may face and be substantially parallel to the incident surface 301 while being spaced apart from the incident surfaces 301 by a predetermined distance. According to an embodiment, the incident surface 301 and the exit surface 304 may face in opposite directions, and the first reflective surface 302 and the second reflective surface 303 may face in opposite directions. According to an embodiment, the optical member 300 may have a parallelogram cross-sectional shape in which the incident surface 301 and the exit surface 304 are substantially parallel, and the first reflective surface 302 and the second reflective surface 303 are substantially parallel. According to an embodiment, the optical member 300 may be referred to as a parallelogram, a rhombic shape, or a rhomboid considering its shape. According to an embodiment, the incident surface 301 may be expressed as being inclined in the same direction as the exit surface 304, and the first reflective surface 302 may be expressed as being inclined in the same direction as the second reflective surface 303. Referring to FIG. 1, for the light passing through the optical member 300, the direction in which the light is incident and the direction in which the light exits may face in the same direction.

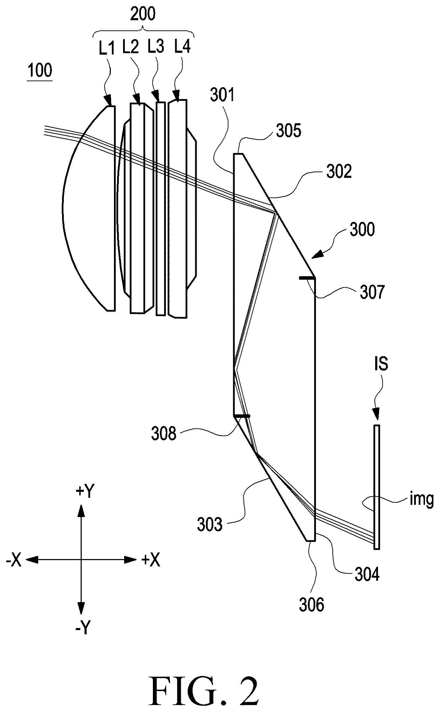

FIG. 2 is a diagram illustrating an example camera module including an optical member according to an embodiment of the disclosure. FIG. 2 may illustrate a state in which stray light (or flare) is incident on the image sensor IS.

Referring to FIGS. 1 and 2 together, the first reflective surface 302 may be formed to be inclined with respect to the incident surface 301. The angle between the incident surface 301 and the first reflective surface 302 of the optical member 300 may be determined according to specifications required for the camera module including the optical member. In general, when the angle between the incident surface 301 and the first reflective surface 302 is a very small acute angle (e.g., when sharp), it may be difficult to handle the lens (e.g., to insert the lens into the lens barrel) in the process of assembling the camera module 100. The angle between the incident surface 301 and the first reflective surface 302 may be set considering the assemblability of the camera module 100.

The optical member 300 may include a cutting plane. In the optical member 300, a first cutting plane 305 inclined with respect to the incident surface 301 and the first reflective surface 302 may be formed at an edge of the first reflective surface 302, and a second cutting plane 306 inclined with respect to the exit surface 304 and the second reflective surface 303 may be formed at an edge of the second reflective surface 303. At least a portion of the light incident on the optical member 300 that causes the stray light may be removed by the first cutting plane 305 and/or the second cutting plane 306. The first cutting plane 305 and/or the second cutting plane 306 may be parallel to the traveling direction of light parallel to the optical axis O-I, but is not necessarily limited thereto, and may be formed to be inclined with respect to the traveling direction of light parallel to the optical axis O-I. When the material of the optical member 300 is, e.g., a glass material, it is possible to prevent and/or reduce damage to the optical member 300 when handling the optical member 300 by including the first cutting plane 305 and the second cutting plane 306.

The optical member 300 may include a shielding structure as a structure for reducing and/or preventing stray light. The optical member 300 may include a first shielding structure 307 disposed on a portion of the exit surface 304 adjacent to the first reflective surface 302 and a second shielding structure 308 disposed on a portion of the incident surface 301 adjacent to the second reflective surface 303. At least a portion of the light which causes the stray light, of the light incident on the optical member 300, may be blocked by the first shielding structure 307 and the second shielding structure 308. The optical member 300 may reduce and/or prevent the generation of stray light by including the first shielding structure 307 and the second shielding structure 308.

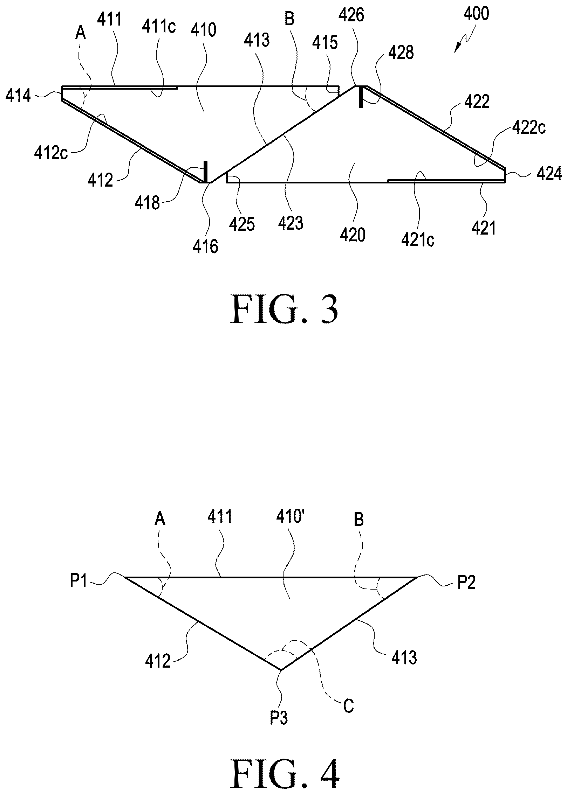

According to various embodiments of the disclosure described in greater detail below with reference to FIG. 3, an optical member 400 for reducing and/or preventing stray light may be provided in addition to or instead of the above-described structure for reducing and/or preventing stray light.

FIG. 3 is a diagram illustrating an example optical member according to an embodiment of the disclosure.

Referring to FIG. 3, an optical member 400 (e.g., the optical member 300 of FIGS. 1 and 2) may include a first optical member 410 and a second optical member 420. The first optical member 410 and the second optical member 420, which are separated from each other, may be coupled to each other to form the optical member 400 shaped as a parallelogram, a rhombus, or a rhomboid. Here, 'coupling' may refer to a concept that encompasses all physical connections between a component and another component, such as assembling, fastening, and bonding.

The optical member 400 may include a first optical member 410 having a triangular column shape and configured to allow light passing through the at least one lens to be incident through at least one surface thereof, and a second optical member 420 having a triangular column shape and configured to allow light to exit through at least one surface thereof and configured to face the first optical member 410 through at least another surface thereof. As illustrated in FIG. 3, each of the first optical member 410 and the second optical member 420 may have a triangular column shape. According to an embodiment, the first optical member 410 and the second optical member 420 may have substantially the same shape.

The first optical member 410 may include a first surface 411 on which light passing through at least one lens is incident, and a second surface 412 inclined with the first surface 411. Further, the first optical member 410 may include a third surface 413 inclined with respect to the first surface 411 and the second surface 412. The second optical member 420 may include a fourth surface 421 through which light exits and a fifth surface 422 inclined with respect to the fourth surface 421. Further, the second optical member 420 may include a sixth surface 423 inclined with respect to the fourth surface 421 and the fifth surface 422. When the first optical member 410 and the second optical member 420 are coupled to each other to form one optical member 400, the first surface 411 of the first optical member 410 may correspond to the incident surface 301 illustrated in FIGS. 1 and 2, and the second surface 412 may correspond to the first reflective surface 302 of the embodiment illustrated in FIGS. 1 and 2. The fourth surface 421 of the second optical member 420 may correspond to the exit surface 304 illustrated in FIGS. 1 and 2, and the fifth surface 422 may correspond to the second reflective surface 303 illustrated in FIGS. 1 and 2. The third surface 413 of the first optical member 410 may face the sixth surface 423 of the second optical member 420. According to an embodiment, the third surface 413 of the first optical member 410 and the sixth surface 423 of the second optical member 420 may be bonded to each other. For example, a bonding material (e.g., UV epoxy) may be provided on at least one of the third surface 413 of the first optical member 410 and the sixth surface 423 of the second optical member 420, and the third surface 413 of the first optical member 410 and the sixth surface 423 of the second optical member 420 may be bonded to each other by the bonding material (e.g., after the UV epoxy is cured).

Anti-reflection (AR) coating layers 411c and 421c may be formed on the first surface 411 of the first optical member 410 on which light is incident and the fourth surface 421 of the second optical member 420 which light exits, respectively. For example, according to an embodiment, a coating capable of blocking light of about 700 nm or more by about 80% or more may be applied to the first surface 411 and/or the fourth surface 421 of the optical member 400. By allowing the first surface 411 and/or the fourth surface 421 to block light of approximately 700 nm or more by 80% or more, light rays (e.g., infrared rays) having a designated frequency or a higher frequency may be blocked. Further, mirror coating layers 412c and 422c may be formed on the second surface 412 of the first optical member 410 and the fifth surface 422 of the second optical member 420, respectively. The optical member 400 may increase the reflectivity of the surface in the traveling direction of light by including the mirror coating layers 412c and 422c. Light incident on the first surface 411 of the first optical member 410 may be reflected and/or refracted more than n times (where n is a natural number) while passing through the optical member 400 in a state in which leakage to the outside of the optical member 400 is reduced and/or prevented by the AR coating layers 411c and 421c and/or the mirror coating layers 412c and 422c, and then may exit through the fourth surface 421 of the second optical member 420.

The optical member 400 may include a cutting plane. The first optical member 410 may include, at an edge of the first surface 411, a first cutting plane 414 inclined with respect to the first surface 411 and the second surface 412. The first cutting plane 414 of the first optical member 410 may correspond to the first cutting plane 305 illustrated in FIG. 2. According to an embodiment, the first cutting plane 414 may be formed to form a right angle with respect to the first surface 411. However, this is merely an example, and the first cutting plane 414 may be formed to be inclined by an angle other than a right angle with respect to the first surface 411 and/or the second surface 412. According to an embodiment, the first optical member 410 may include, at another edge of the first surface 411, a second cutting plane 415 inclined with respect to the first surface 411 and the third surface 413. According to an embodiment, the first optical member 410 may include a third cutting plane 416 inclined with respect to the second surface 412 and the third surface 413. The second optical member 420 may include, at an edge of the fourth surface 421, a fourth cutting plane 424 inclined with respect to the fourth surface 421 and the fifth surface 422. The fourth cutting plane 424 of the second optical member 420 may correspond to the second cutting plane 306 illustrated in FIG. 2. According to an embodiment, the fourth cutting plane 424 may be formed to form a right angle with respect to the fourth surface 421. However, this is merely an example, and the fourth cutting plane 424 may be formed to be inclined with respect to the fourth surface 421 and/or the fifth surface 422 by an angle other than a right angle. According to an embodiment, the second optical member 420 may include, at another edge of the fourth surface 421, a fifth cutting plane 425 inclined with respect to the fourth surface 421 and the sixth surface 423. According to an embodiment, the second optical member 420 may include a sixth cutting plane 426 inclined with respect to the fifth surface 422 and the sixth surface 423. The first optical member 410 and the second optical member 420 may have the cutting plane(s) 414, 415, 416, 424, 425, and 426, and may be coupled with the respective surfaces thereof facing each other. At least a portion of the light incident on the optical member 400 that causes the stray light may be removed by at least one of the cutting plane(s) 414, 415, 416, 424, 425, and 426.

The optical member 400 may include a shielding structure as a structure for reducing and/or preventing stray light. The optical member 400 may include a first shielding structure 418 disposed between the second surface 412 and the third surface 413 of the first optical member 410 and a second shielding structure 428 disposed between the fifth surface 422 and the sixth surface 423 of the second optical member 420. According to an embodiment, the first shielding structure 418 and the second shielding structure 428 may be formed on the third cutting plane 416 and the sixth cutting plane 426, respectively. According to an embodiment, the first shielding structure 418 and the second shielding structure 428 may be structures that have notches formed on the third cutting plane 416 and the sixth cutting plane 426, respectively, and are formed by treating the notches with black lacquer. According to an embodiment, the third cutting plane 416 and the sixth cutting plane 426 may be corroded. At least a portion of the light incident on the optical member 400 that causes the stray light may be blocked by the first shielding structure 418 and the second shielding structure 428. The optical member 400 may reduce and/or prevent the generation of stray light by including the first shielding structure 418 and the second shielding structure 428.

The angle A between the first surface 411 and the second surface 412 of the first optical member 410 and the angle B between the first surface 411 and the third surface 413 may be set as various angles according to embodiments. According to an embodiment, the angle A between the first surface 411 and the second surface 412 of the first optical member 410 and the angle B between the first surface 411 and the third surface 413 may be formed to differ from each other. For example, the angle A between the first surface 411 and the second surface 412 of the first optical member 410 may meet Formula 1 below, and the angle B between the first surface 411 and the third surface 413 of the first optical member 410 may meet Formula 2 below.

$$[\text{Formula 1}]$$

$$25° \leq A \leq 35°$$

$$[\text{Formula 2}]$$

$$25° \leq B \leq 50°$$

According to an embodiment, the angle A between the first surface 411 and the second surface 412 of the first optical member 410 may be smaller than the angle B between the first surface 411 and the third surface 413 under the assumption that Formulas 1 and 2 are met. For example, the angle A between the first surface 411 and the second surface 412 of the first optical member 410 may be 25°, and the angle B between the first surface 411 and the third surface 413 may be 35°. In this case, the angle between the second surface 412 and the third surface 413 may be 120° as an obtuse angle. According to an embodiment, when the lower limit of Formula 1 and Formula 2 is exceeded, the light path may be shortened, making it difficult to apply to a telephoto lens having a long focal length, and when the upper limit is exceeded, the light path may be lengthened, making it difficult to apply to a small electronic device such as a smartphone.

Referring back to FIG. 3, the optical member 400 according to various embodiments of the disclosure is a combination of the first optical member 410 and the second optical member 420 having an obtuse prism structure rather than a right prism shape. The optical member 400 of the disclosure may be applied to a high magnification telephoto camera having a long total length.

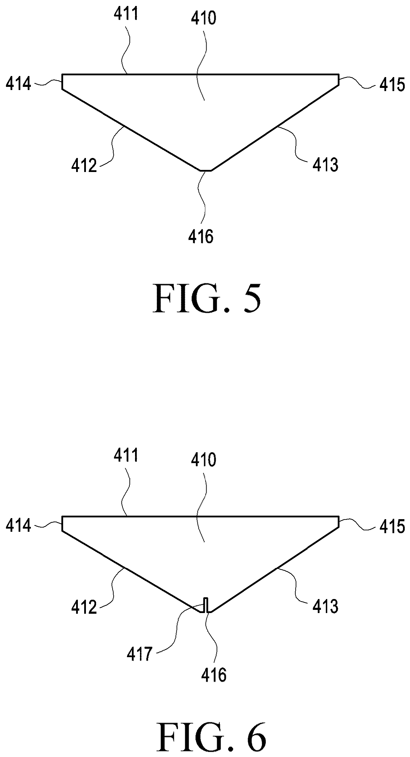

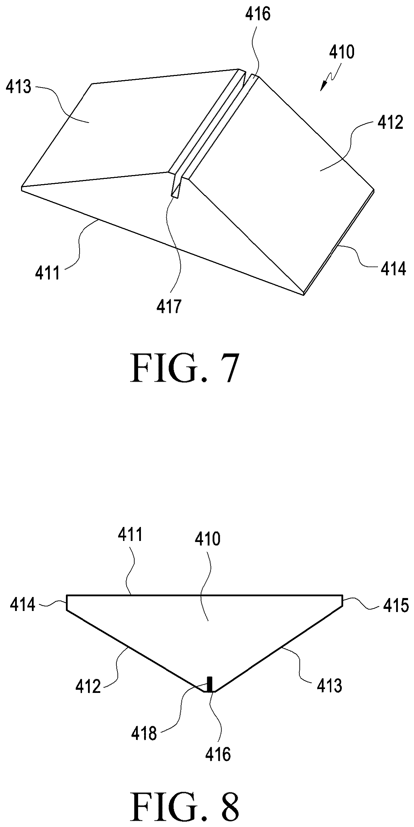

FIG. 4 is a diagram illustrating an example optical member base material according to an embodiment of the disclosure. FIG. 5 is a diagram illustrating an example optical member base materialhaving a cutting plane according to an embodiment of the disclosure. FIG. 6 is a diagram illustrating an example optical member base material having a notch according to disclosure. FIG. 7 is a perspective view illustrating an optical member base material having a notch according to an embodiment of the disclosure. FIG. 8 is a diagram illustrating an example optical member according to an embodiment of the disclosure. A method for manufacturing an optical member 400 may be described with reference to the embodiments of FIGS. 4 to 8. Embodiments of FIGS. 4 to 8 may be illustrated for the first optical member 410, which may also be applied to the second optical member 420.

Referring to FIG. 4, a base material 410' of the first optical member is provided. The base material 410' of the first optical member may be a triangular column having three vertices P1, P2, and P3 in cross section. The base material 410' of the first optical member may include a first surface 411, a second surface 412, and a third surface 413, and the angle A between the first surface 411 and the second surface 412 may be an acute angle in a range of 25°≤A≤35°, and the angle B between the first surface 411 and the third surface 413 may also be an acute angle in a range of 25°≤B≤50°. When the angles A and B are determined, the angle C between the second surface 412 and the third surface 413 may be automatically determined in an obtuse angle range.

Referring to FIGS. 5 and 6, cutting planes 414, 415, and 416 may be formed at three vertices of the base material 410' of the first optical member. A notch 417 may be formed to have a predetermined depth in the third cutting plane 416 of the base material 410' of the first optical member. In this case, the depth of the notch may be set not to exceed 50% of the thickness of the base material 410' of the optical member. FIG. 7 may be a perspective view illustrating the base material 410' of the first optical member having the notch 417 illustrated in FIG. 6. The notch 417 may be elongated along a height (or thickness) direction of the base material 410' of the first optical member.

Referring to FIG. 8, a light opaque material may be formed in the notch 417 of the base material 410' of the first optical member, thereby forming the first shielding structure 418. For example, the notch 417 may be filled with a shielding material that blocks light, or the notch 417 may be blackened to form the first shielding structure 418.

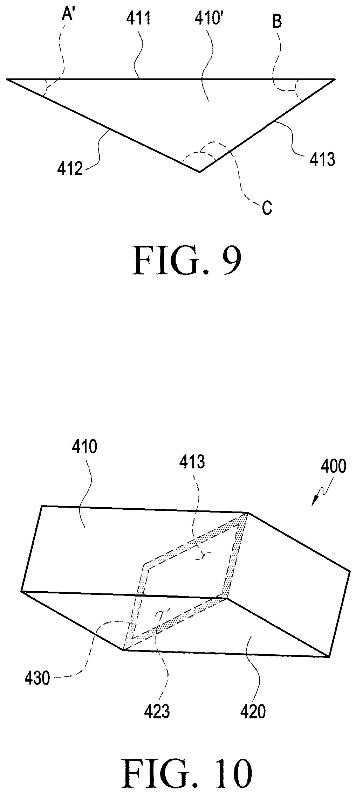

FIG. 9 is a diagram illustrating an example optical member base material 410' according to an embodiment of the disclosure.

It may be required to change the light path inside the optical member according to the focal length of the lens. For example, the length of the light path inside the optical member may be required to be increased or decreased according to the focal length of the lens. In order to increase or decrease the length of the light path, the angle of the inclined plane (e.g., the second surface 412 or the third surface 413) of one side of the triangular column may be changed in the optical member base material 410'. In this regard, the angle A' between the first surface 411 and the second surface 412 of the first optical member base material 410' and the angle B' between the first surface 411 and the third surface 413 may be set to differ according to an embodiment. For example, in order to change (e.g., increase) the traveling path of light corresponding to the focal length of the lens (or lens group), the angle A' between the first surface 411 and the second surface 412 of the first optical member base material 410' may be decreased compared to the embodiment illustrated in FIG. 4, and the angle B' between the first surface 411 and the third surface 413 may be increased compared to the embodiment illustrated in FIG. 4. Of course, the opposite is possible. According to an embodiment, the light path may be changed by fixing the angle A' between the first surface 411 and the second surface 412 of the first optical member base material 410' and adjusting the angle B' between the first surface 411 and the third surface 413 and the angle C' between the second surface 412 and the third surface 413. According to an embodiment, the light path may be changed by fixing the angle B' between the first surface 411 and the third surface 413 of the first optical member base material 410' and adjusting the angle A' between the first surface 411 and the second surface 412 and the angle C' between the second surface 412 and the third surface 413.

The first optical member 410 formed according to the embodiment illustrated In FIGS. 4 to 9 and the second optical member 420 formed in a similar manner thereto may be coupled to each other to form the optical member 400 of the disclosure.

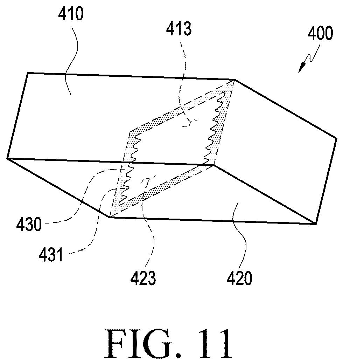

FIG. 10 is a perspective view illustrating an example optical member having a blocking film according to an embodiment of the disclosure. FIG. 11 is a perspective view illustrating an example optical member having a blocking film according to an embodiment of the disclosure;

The optical member 400 may include a blocking film 430 formed along an edge of at least one of the third surface 413 of the first optical member 410 and the sixth surface 423 of the second optical member 420 as another component for reducing and/or preventing stray light. By including the blocking film 430, it is possible to reduce and/or prevent stray light (or flare) due to reflection at the side portion when the two optical members 410 and 420 are coupled to each other. For example, the blocking film 430 may include, e.g., a film coated or painted with a material that blocks light, or a film that blocks light.

According to an embodiment, the blocking layer 430 may include irregularities 431. The blocking film 430 is formed by a predetermined height along the edge of at least one of the third surface 413 of the first optical member 410 and the sixth surface 423 of the second optical member 420, and the blocking film 430 may further include the irregularities 431 (refer to FIG. 11) to reduce and/or prevent an influence by diffraction of stray light (or flare). In an embodiment, the optical member 400 may include irregularities 431 in at least one of sides (e.g., four sides) of the blocking layer 430.

As illustrated in FIGS. 10 and 11, the optical member 400 including the first optical member 410 and the second optical member 420 of the disclosure may include the blocking film 430 in a direction inclined with respect to the path through which light is incident and/or exits, thereby more effectively reducing and/or preventing stray light.

FIG. 12 is a block diagram illustrating an example electronic device 1201 (e.g., the camera module 100 of FIG. 1) (e.g., optical device) in a network environment 1200 according to various embodiments.

Referring to FIG. 12, the electronic device 1201 (e.g., an optical device0 in the network environment 1200 may communicate with at least one of an electronic device 1202 via a first network 1298 (e.g., a short-range wireless communication network), or an electronic device 1204 or a server 1208 via a second network 1299 (e.g., a long-range wireless communication network). According to an embodiment, the electronic device 1201 may communicate with the electronic device 1204 via the server 1208. According to an embodiment, the electronic device 1201 may include a processor 1220, memory 1230, an input module 1250, a sound output module 1255, a display module 1260, an audio module 1270, a sensor module 1276, an interface 1277, a connecting terminal 1278, a haptic module 1279, a camera module 1280, a power management module 1288, a battery 1289, a communication module 1290, a subscriber identification module (SIM) 1296, or an antenna module 1297. In some embodiments, at least one (e.g., the display module 1260 or the camera module 1280) of the components may be omitted from the electronic device 1201, or one or more other components may be added in the electronic device 101. According to an embodiment, some (e.g., the sensor module 1276, the camera module 1280, or the antenna module 1297) of the components may be integrated into a single component (e.g., the display module 1260).

The processor 1220 may include various processing circuitry and/or multiple processors. For example, as used herein, including the claims, the term "processor" may include various processing circuitry, including at least one processor, wherein one or more of at least one processor, individually and/or collectively in a distributed manner, may be configured to perform various functions described herein. As used herein, when "a processor", "at least one processor", and "one or more processors" are described as being configured to perform numerous functions, these terms cover situations, for example and without limitation, in which one processor performs some of recited functions and another processor(s) performs other of recited functions, and also situations in which a single processor may perform all recited functions. Additionally, the at least one processor may include a combination of processors performing various of the recited /disclosed functions, e.g., in a distributed manner. At least one processor may execute program instructions to achieve or perform various functions. The processor 1220 may execute, for example, software (e.g., a program 1240) to control at least one other component (e.g., a hardware or software component) of the electronic device 1201 coupled with the processor 1220, and may perform various data processing or computation. According to an embodiment, as at least part of the data processing or computation, the processor 1220 may store a command or data received from another component (e.g., the sensor module 1276 or the communication module 1290) in volatile memory 1232, process the command or the data stored in the volatile memory 1232, and store resulting data in non-volatile memory 1234. According to an embodiment, the processor 1220 may include a main processor 1221 (e.g., a central processing unit (CPU) or an application processor (AP)), or an auxiliary processor 1223 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 1201 includes the main processor 1221 and the auxiliary processor 1223, the auxiliary processor 1223 may be configured to use lower power than the main processor 1221 or to be specified for a designated function. The auxiliary processor 1223 may be implemented as separate from, or as part of the main processor 1221.

The auxiliary processor 1223 may control' at least some of functions or states related to at least one component (e.g., the display module 1260, the sensor module 1276, or the communication module 1290) among the components of the electronic device 1201, instead of the main processor 1221 while the main processor 1221 is in an inactive (e.g., sleep) state, or together with the main processor 1221 while the main processor 1221 is in an active state (e.g., executing an application). According to an embodiment, the auxiliary processor 1223 (e.g., an image signal processor or a communication processor) may be implemented as part of another component (e.g., the camera module 1280 or the communication module 1290) functionally related to the auxiliary processor 123. According to an embodiment, the auxiliary processor 1223 (e.g., the neural processing unit) may include a hardware structure specified for artificial intelligence model processing. The artificial intelligence model may be generated via machine learning. Such learning may be performed, e.g., by the electronic device 1201 where the artificial intelligence is performed or via a separate server (e.g., the server 1208). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1230 may store various data used by at least one component (e.g., the processor 1220 or the sensor module 1276) of the electronic device 1201. The various data may include, for example, software (e.g., the program 1240) and input data or output data for a command related thereto. The memory 1230 may include the volatile memory 1232 or the non-volatile memory 1234.

The program 1240 may be stored In the memory 1230 as software, and may be, for example, an operating system (OS) 1242, middleware 1244, or an application 1246.

The input module 1250 may receive a command or data to be used by other component (e.g., the processor 1220) of the electronic device 1201, from the outside (e.g., a user) of the electronic device 1201. The input module 1250 may include, for example, a microphone, a mouse, a keyboard, keys (e.g., buttons), or a digital pen (e.g., a stylus pen).

The sound output module 1255 may output sound signals to the outside of the electronic device 1201. The sound output module 1255 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1260 may visually provide Information to the outside (e.g., a user) of the electronic device 1201. The display 1260 may include, for example, a display, a hologram device, or a projector and control circuitry to control a corresponding one of the display, hologram device, and projector. According to an embodiment, the display 1260 may include a touch sensor configured to detect a touch, or a pressure sensor configured to measure the intensity of a force generated by the touch.

The audio module 1270 may convert a sound into an electrical signal and vice versa. According to an embodiment, the audio module 1270 may obtain the sound via the input module 1250, or output the sound via the sound output module 1255 or a headphone of an external electronic device (e.g., an electronic device 1202) directly (e.g., wiredly) or wirelessly coupled with the electronic device 1201.

The sensor module 1276 may detect an operational state (e.g., power or temperature) of the electronic device 1201 or an environmental state (e.g., a state of a user) external to the electronic device 101, and then generate an electrical signal or data value corresponding to the detected state. According to an embodiment, the sensor module 1276 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 1277 may support one or more specified protocols to be used for the electronic device 1201 to be coupled with the external electronic device (e.g., the electronic device 1202) directly (e.g., wiredly) or wirelessly. According to an embodiment, the interface 1277 may include, for example, a high definition multimedia interface (HDMI), a universal serial bus (USB) interface, a secure digital (SD) card interface, or an audio interface.

A connecting terminal 1278 may include a connector via which the electronic device 1201 may be physically connected with the external electronic device (e.g., the electronic device 1202). According to an embodiment, the connecting terminal 1278 may include, for example, a HDMI connector, a USB connector, a SD card connector, or an audio connector (e.g., a headphone connector).

The haptic module 1279 may convert an electrical signal into a mechanical stimulus (e.g., a vibration or motion) or electrical stimulus which may be recognized by a user via his tactile sensation or kinesthetic sensation. According to an embodiment, the haptic module 1279 may include, for example, a motor, a piezoelectric element, or an electric stimulator.

The camera module 1280 may capture a still image or moving images. According to an embodiment, the camera module 1280 may include one or more lenses, image sensors, image signal processors, or flashes.

The power management module 1288 may manage power supplied to the electronic device 1201. According to an embodiment, the power management module 1288 may be implemented as at least part of, for example, a power management integrated circuit (PMIC).

The battery 1289 may supply power to at least one component of the electronic device 1201. According to an embodiment, the battery 1289 may include, for example, a primary cell which is not rechargeable, a secondary cell which is rechargeable, or a fuel cell.

The communication module 1290 may support establishing a direct (e.g., wired) communication channel or a wireless communication channel between the electronic device 1201 and the external electronic device (e.g., the electronic device 1202, the electronic device 1204, or the server 1208) and performing communication via the established communication channel. The communication module 1290 may include one or more communication processors that are operable independently from the processor 1220 (e.g., the application processor (AP)) and supports a direct (e.g., wired) communication or a wireless communication. According to an embodiment, the communication module 1290 may include a wireless communication module 1292 (e.g., a cellular communication module, a short-range wireless communication module, or a global navigation satellite system (GNSS) communication module) or a wired communication module 1294 (e.g., a local area network (LAN) communication module or a power line communication (PLC) module). A corresponding one of these communication modules may communicate with the external electronic device 1204 via a first network 1298 (e.g., a short-range communication network, such as Bluetooth™, wireless-fidelity (Wi-Fi) direct, or infrared data association (IrDA)) or a second network 1299 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 1292 may identify or authenticate the electronic device 1201 in a communication network, such as the first network 1298 or the second network 1299, using subscriber information (e.g., international mobile subscriber identity (IMSI)) stored in the subscriber identification module 1296.

The wireless communication module 1292 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1292 may support a high-frequency band (e.g., the mmWave band) to achieve, e.g., a high data transmission rate. The wireless communication module 1292 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1292 may support various requirements specified in the electronic device 1201, an external electronic device (e.g., the electronic device 1204), or a network system (e.g., the second network 1299). According to an embodiment, the wireless communication module 1292 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 1297 may transmit or receive a signal or power to or from the outside (e.g., the external electronic device). According to an embodiment, the antenna module 1297 may include one antenna including a radiator formed of a conductor or conductive pattern formed on a substrate (e.g., a printed circuit board (PCB)). According to an embodiment, the antenna module 1297 may include a plurality of antennas (e.g., an antenna array). In this case, at least one antenna appropriate for a communication scheme used in a communication network, such as the first network 1298 or the second network 1299, may be selected from the plurality of antennas by, e.g., the communication module 1290. The signal or the power may then be transmitted or received between the communication module 1290 and the external electronic device via the selected at least one antenna. According to an embodiment, other parts (e.g., radio frequency integrated circuit (RFIC)) than the radiator may be further formed as part of the antenna module 1297.

According to various embodiments, the antenna module 1297 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, instructions or data may be transmitted or received between the electronic device 1201 and the external electronic device 1204 via the server 1208 coupled with the second network 1299. The external electronic devices 1202 and 1204 each may be a device of the same or a different type from the electronic device 1201. According to an embodiment, all or some of operations to be executed at the electronic device 1201 may be executed at one or more of the external electronic devices 1202, 1204, or 1208. For example, if the electronic device 1201 should perform a function or a service automatically, or in response to a request from a user or another device, the electronic device 1201, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1201. The electronic device 1201 may provide the outcome, with or without further processing of the outcome, as at least part of a reply to the request. To that end, a cloud computing, distributed computing, mobile edge computing (MEC), or client-server computing technology may be used, for example.

The electronic device 1201 may provide ultra low-latency services using, e.g., distributed computing or mobile edge computing. In an embodiment, the external electronic device 1204 may include an internet-of-things (IoT) device. The server 1208 may be an intelligent server using machine learning and/or a neural network. According to an embodiment, the external electronic device 1204 or the server 1208 may be included in the second network 1299. The electronic device 1201 may be applied to intelligent services (e.g., smart home, smart city, smart car, or healthcare) based on 5G communication technology or IoT-related technology.

FIG. 13 is a block diagram 1300 illustrating an example configuration of a camera module 1380 according to various embodiments.

Referring to FIG. 13, the camera module 1380 may include a lens assembly 1310 (e.g., a lens assembly including the lens group 200 and the optical member 300 or 400), a flash 1320, an image sensor 1330 (e.g., IS), an image stabilizer (e.g., including image stabilization circuitry) 1340, memory 1350 (e.g., buffer memory (e.g., the memory 1230 of FIG. 12)), and/or an image signal processor (e.g., including processing circuitry) 1360. The lens assembly 1310 may collect light emitted or reflected from an object whose image is to be taken. The lens assembly 1310 may include one or more lenses. According to an embodiment, the camera module 1380 may include a plurality of lens assemblies 1310. In this case, the camera module 1380 may form, e.g., a dual-camera, a 360-degree camera, or a spherical camera. Some of the plurality of lens assemblies 1310 may have the same lens attribute (e.g., view angle, focal length, auto-focusing, f number (Fno), or optical zoom), or at least one lens assembly may have one or more lens attributes different from those of another lens assembly. The lens assembly 1310 may include, for example, a wide-angle lens or a telephoto lens.

The flash 1320 may emit light that is used to reinforce light reflected from an object. According to an embodiment, the flash 1320 may include one or more light emitting diodes (e.g., a red-green-blue (RGB) LED, a white LED, an infrared LED, or an ultraviolet LED), or a xenon lamp. The image sensor 1330 may obtain an image corresponding to an object by converting light emitted or reflected from the object and transmitted via the lens assembly 1310 into an electrical signal. According to an embodiment, the image sensor 1330 may include one selected from image sensors having different attributes, such as a RGB sensor, a black-and-white (BW) sensor, an IR sensor, or a UV sensor, a plurality of image sensors having the same attribute, or a plurality of image sensors having different attributes. Each image sensor included in the image sensor 1330 may be implemented using, e.g., a charged coupled device (CCD) sensor or a complementary metal oxide semiconductor (CMOS) sensor.

The image stabilizer 1340 may include various circuitry and move the mage sensor 1330 or at least one lens included in the lens assembly 1310 in a particular direction, or control an operational attribute (e.g., adjust the read-out timing) of the image sensor 1330 in response to the movement of the camera module 1380 or the electronic device 1201 including the camera module 180. This makes it possible to compensate for at least some of the negative effects of the movement on the image being taken. According to an embodiment, the image stabilizer 1340 may sense such a movement by the camera module 1380 or the electronic device 1201 using a gyro sensor (not shown) or an acceleration sensor (not shown) disposed inside or outside the camera module 1380. According to an embodiment, the image stabilizer 1340 may be implemented as, e.g., an optical image stabilizer. The memory 1350 may store, at least temporarily, at least part of an image obtained via the image sensor 1330 for a subsequent image processing task. For example, if image capturing is delayed due to shutter lag or multiple images are quickly captured, a raw image obtained (e.g., a Bayer-patterned image, a high-resolution image) may be stored in the memory 1350, and its corresponding copy image (e.g., a low-resolution image) may be previewed via the display module 1260. Thereafter, if a specified condition is met (e.g., by a user's input or system command), at least part of the raw image stored in the memory 1350 may be obtained and processed, for example, by the image signal processor 1360. According to an embodiment, the memory 1350 may be configured as at least part of the memory 1230 of FIG. 12 or as a separate memory that is operated independently from the memory.

The image signal processor 1360 may include various circuitry and perform one or more image processing with respect to an image obtained via the image sensor 1330 or an image stored in the memory 1350. The one or more image processing may include, for example, depth map generation, three-dimensional (3D) modeling, panorama generation, feature point extraction, image synthesizing, or image compensation (e.g., noise reduction, resolution adjustment, brightness adjustment, blurring, sharpening, or softening). Additionally or alternatively, the image signal processor 1360 may perform control (e.g., exposure time control or read-out timing control) with respect to at least one (e.g., the image sensor 1330) of the components included in the camera module 1380. An image processed by the image signal processor 1360 may be stored back in the memory 1350 for further processing, or may be provided to an external component (e.g., the memory 1230, the display module 1260, the electronic device 1202, the electronic device 1204, or the server 1208) outside the camera module 1380. According to an embodiment, the image signal processor 1360 may be configured as at least part of the processor 1220, or as a separate processor that is operated independently from the processor 1220. If the image signal processor 1360 is configured as a separate processor from the processor 1220, at least one image processed by the image signal processor 1360 may be displayed, by the processor 1360, via the display module 1360 as it is or after being further processed.

According to an embodiment, the electronic device 1201 may include a plurality of camera modules 1380 having different attributes or functions. In such a case, at least one of the plurality of camera modules 1380 may form, for example, a wide-angle camera and at least another of the plurality of camera modules may form a telephoto camera. Similarly, at least one of the plurality of camera modules 1380 may be a front camera and at least another of the plurality of camera modules may be a rear camera.

The electronic device according to various embodiments may be one of various types of devices. The electronic devices may include, for example, a portable communication device (e.g., a smartphone), a computer device, a portable multimedia device, a portable medical device, a camera, a wearable device, a home appliance, or the like. The electronic devices according to an embodiment are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), the element may be coupled with the other element directly (e.g., wiredly), wirelessly, or via a third element.

As used herein, the term "module" may include a unit implemented in hardware, software, firmware, or any combination thereof, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 1240) including one or more instructions that are stored in a storage medium (e.g., internal memory 1236 or external memory 1238) that is readable by a machine (e.g., the electronic device 1201). For example, a processor (e.g., the processor 1220) of the machine (e.g., the electronic device 1201) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the "non-transitory" storage medium is a tangible device, and may not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store™), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

An electronic device 1201 according to an example embodiment of the disclosure may comprise at least one lens, an image sensor IS aligned along an optical axis from the at least one lens, and an optical member disposed between the at least one lens and the image sensor on the optical axis. The optical member may include a first optical member 410 including a first surface 411 on which light passing through the at least one lens is configured to be incident, a second surface 412 inclined with respect to the first surface, and a third surface 413 inclined with respect to the first surface and the second surface, and a second optical member 420 including a fourth surface 421 through which light is configured to exit, a fifth surface 422 inclined with respect to the fourth surface, and a sixth surface 423 inclined with respect to the fourth surface and the fifth surface and facing the third surface.

According to an example embodiment, the optical member may include at least one of a prism, a mirror reflecting light, and/or an aperture.

According to an example embodiment, each of the first optical member and the second optical member may have, in a cross section, an obtuse triangular prism shape.

According to an example embodiment, the first optical member and the second optical member may have substantially the same shape.

According to an example embodiment, an angle A between the first surface and the second surface of the first optical member and an angle B between the first surface and the third surface may be different from each other.

According to an example embodiment, an angle A between the first surface and the second surface of the first optical member may meet the following [Formula 1].

[Formula 1]

$$25° \leq A \leq 35°$$

According to an example embodiment, an angle B between the first surface and the third surface of the first optical member may meet the following [Formula 2].

[Formula 2]

$$25° \leq B \leq 50°$$

According to an example embodiment, the third surface of the first optical member and the sixth surface of the second optical member may be bonded to each other.

According to an example embodiment, the second surface of the first optical member and the fifth surface of the second optical member may include a mirror coating layer.

According to an example embodiment, the first surface of the first optical member and the fourth surface of the second optical member may include an AR coating layer.

According to an example embodiment, the first optical member may include a cutting plane formed between two different surfaces among the first surface, the second surface, and the third surface.

According to an example embodiment, the first optical member may be notched at a position where the second surface and the third surface meet, and a light opaque material may be disposed in the notch.

According to an example embodiment, the electronic device may further comprise a blocking film provided along an edge of at least one of the third surface of the first optical member or the sixth surface of the second optical member.

According to an example embodiment, the blocking film may include irregularities in at least one of four sides of the blocking film.

According to an example embodiment, the at least one lens, the image sensor, and the optical member may comprise a folded optical system.

An electronic device 1201 according to an example embodiment of the disclosure may comprise: at least one lens, an image sensor IS aligned along an optical axis from the at least one lens, and an optical member disposed between the at least one lens and the image sensor on the optical axis. The optical member may include a first optical member 410 having a triangular column shape and configured to allow light passing through the at least one lens to be incident through at least one surface thereof, and a second optical member 420 having a triangular column shape, configured to allow light to exit through at least one surface thereof, and configured to face the first optical member through at least one other surface thereof.

According to an embodiment, the optical member may include at least one component among a prism, a mirror reflecting light, and/or an aperture.

According to an embodiment, the first optical member and the second optical member may have substantially the same shape.

According to an embodiment, an angle A between the first surface and the second surface of the first optical member and an angle B between the first surface and the third surface may be different from each other.

According to an example embodiment, an angle A between the first surface and the second surface of the first optical member may meet the following [Formula 1], and an angle B between the first surface and the third surface of the first optical member may meet the following [Formula 2].

[Formula 1]

$$25° \leq A \leq 35°$$

[Formula 2]

$$25° \leq B \leq 50°$$

Effects obtainable by the disclosure are not limited to the above-mentioned effects, and other effects not mentioned may be apparent to one of ordinary skill in the art.

While the present disclosure has been illustrated and described with reference to various example embodiments thereof, it will be apparent to those of ordinary skill in the art that various changes in form and detail may be made thereto without departing from scope of the disclosure, including the appended claims and their equivalents. For example, in specific embodiments of the disclosure, the measurements of at least three lenses may be properly set depending on the structure, specifications, or actual use environment of the lens assembly as actually manufactured or a camera and/or an electronic device equipped with the lens assembly.

**Claims**

1. An electronic device (1201) comprising:

   at least one lens;
   an image sensor (IS) aligned along an optical axis from the at least one lens; and
   an optical member disposed between the at least one lens and the image sensor on the optical axis,
   wherein the optical member includes:

   a first optical member (410) including a first surface (411) on which light passing through the at least one lens is configured to be incident, a second surface (412) inclined with respect to the first surface, and a third surface (413) inclined with respect to the first surface and the second surface; and
   a second optical member (420) including a fourth surface (421) though which light is configured to exit, a fifth surface (422) inclined with respect to the fourth surface, and a sixth surface (423) inclined with respect to the fourth surface and the fifth surface and configured to face the third surface.

2. The electronic device of claim 1,
   wherein the optical member includes at least one of a prism, a mirror reflecting light, and/or an aperture.

3. The electronic device of claim 1 or 2,
   wherein each of the first optical member and the second optical member has an obtuse triangular prism shape in cross section.

4. The electronic device of any one of claims 1 to 3,
   wherein the first optical member and the second optical member have substantially the same shape.

5. The electronic device of any one of claims 1 to 4,
   wherein an angle (A) between the first surface and the second surface of the first optical member and an angle (B) between the first surface and the third surface are different from each other.

6. The electronic device of any one of claims 1 to 5,
   wherein an angle (A) between the first surface and the second surface of the first optical member meets the following [Formula 1],

   [Formula 1]

   $$25° \leq A \leq 35°$$

7. The electronic device of any one of claims 1 to 6,
   wherein an angle (B) between the first surface and the third surface of the first optical member meets the following [Formula 2],

   [Formula 2]

   $$25° \leq B \leq 50°$$

8. The electronic device of any one of claims 1 to 7,
   wherein the third surface of the first optical member and the sixth surface of the second optical member are bonded to each other.

9. The electronic device of any one of claims 1 to 8,
   wherein the second surface of the first optical member and the fifth surface of the second optical member include a mirror coating layer.

10. The electronic device of any one of claims 1 to 9,
    wherein the first surface of the first optical member and the fourth surface of the second optical member include an AR coating layer.

11. The electronic device of any one of claims 1 to 10,
    wherein the first optical member includes a cutting plane formed between two different surfaces among the first surface, the second surface, and the third surface.

12. The electronic device of any one of claims 1 to 11,
    wherein the first optical member is notched at a position where the second surface and the third surface meet, and a light opaque material is disposed in the notch.

13. The electronic device of any one of claims 1 to 12,
    further comprising
    a blocking film provided along an edge of at least one of the third surface of the first optical member or the sixth surface of the second optical member.

14. The electronic device of claim 13,
    wherein the blocking film includes irregularities in at least one of four sides of the blocking film.

15. The electronic device of any one of claims 1 to 14,
    wherein the at least one lens, the image sensor, and the optical member comprise a folded optical system.

FIG. 1

FIG. 2

FIG. 3

FIG. 4

411    410

414    415

412    413

416

# FIG. 5

411    410

414    415

412    413

417    416

# FIG. 6

416

410

413

412

411

417

414

# FIG. 7

411    410

414

415

412    413

418    416

# FIG. 8

FIG. 9

FIG. 10

# FIG. 11

FIG. 12

EP 4 664 175 A1

1300

1380

CAMERA MODULE

1320

FLASH

1310

LENS
ASSEMBLY

1330

IMAGE SENSOR

1340

IMAGE STABILIZER

1350

MEMORY

1360

IMAGE SIGNAL
PROCESSOR

# FIG. 13

# INTERNATIONAL SEARCH REPORT

| International application No. |
| --- |
| **PCT/KR2024/009603** |

| A. | CLASSIFICATION OF SUBJECT MATTER |
| --- | --- |

**G02B 13/00**(2006.01)i; **G02B 26/08**(2006.01)i; **G02B 17/08**(2006.01)i

According to International Patent Classification (IPC) or to both national classification and IPC

| B. | FIELDS SEARCHED |
| --- | --- |

Minimum documentation searched (classification system followed by classification symbols)

G02B 13/00(2006.01); G01C 15/06(2006.01); G02B 13/18(2006.01); G02B 15/167(2006.01); G02B 27/01(2006.01); G02B 5/04(2006.01); G03B 21/20(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 프리즘(prism), 렌즈(lens), 노치(notch), 둔각(obtuse angle), 및 센서(sensor)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | CN 219266649 U (SAMSUNG ELECTRO-MECHANICS CO., LTD.) 27 June 2023 (2023-06-27)<br>See paragraphs [0010], [0028]-[0029], [0049]-[0066] and [0127]-[0144] and figures 1-2 and 5. | 1,2,5-7,11,15 |
| Y | | 3,4,8-10,12-14 |
| Y | CN 114063373 A (SUNNY OPTICAL (ZHEJIANG) RESEARCH INSTITUTE CO., LTD.) 18 February 2022 (2022-02-18)<br>See paragraphs [0081]-[0090] and figures 1-3. | 3,4,8 |
| Y | US 2022-0163706 A1 (APPLE INC.) 26 May 2022 (2022-05-26)<br>See paragraphs [0030]-[0058] and figures 1A-8F. | 9,10,12-14 |
| A | JP 2007-133096 A (KONICA MINOLTA OPTO INC.) 31 May 2007 (2007-05-31)<br>See paragraphs [0032]-[0137] and figures 1-28. | 1-15 |

✓ Further documents are listed in the continuation of Box C.  ✓ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **14 October 2024** | **15 October 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

International application No.

**PCT/KR2024/009603**

**C.    DOCUMENTS CONSIDERED TO BE RELEVANT**

| Category* | Citation of document, with indication, where appropriate, of the relevant passages | Relevant to claim No. |
|---|---|---|
| A | JP 2009-204557 A (TOPCON CORP.) 10 September 2009 (2009-09-10)<br>See paragraphs [0020]-[0068] and figures 1-17. | 1-15 |

Form PCT/ISA/210 (second sheet) (July 2022)

## INTERNATIONAL SEARCH REPORT
**Information on patent family members**

International application No.

**PCT/KR2024/009603**

| Patent document cited in search report | | | Publication date (day/month/year) | Patent family member(s) | | | Publication date (day/month/year) |
|---|---|---|---|---|---|---|---|
| CN | 219266649 | U | 27 June 2023 | CN | 116893495 | A | 17 October 2023 |
| | | | | KR | 10-2023-0143463 | A | 12 October 2023 |
| | | | | TW | 202340789 | A | 16 October 2023 |
| | | | | TW | M644025 | U | 21 July 2023 |
| | | | | US | 2023-0314775 | A1 | 05 October 2023 |
| CN | 114063373 | A | 18 February 2022 | | None | | |
| US | 2022-0163706 | A1 | 26 May 2022 | CN | 116529640 | A | 01 August 2023 |
| | | | | DE | 112021006104 | T5 | 05 October 2023 |
| | | | | WO | 2022-109323 | A1 | 27 May 2022 |
| JP | 2007-133096 | A | 31 May 2007 | | None | | |
| JP | 2009-204557 | A | 10 September 2009 | JP | 5096964 | B2 | 12 December 2012 |

Form PCT/ISA/210 (patent family annex) (July 2022)